# EUROPEAN PATENT APPLICATION

(11) **EP 4 586 323 A1**
(43) Date of publication of application: **16.07.2025**
(21) Application number: 24187624.2
(22) Date of filing: 10.07.2024
(51) Int. Cl.: H01L 29/08, H01L 21/8249, H01L 27/06, H01L 29/73, H01L 29/735, H01L 29/10, H01L 29/423, H01L 29/78, H01L 27/12, H01L 27/02

(54) **BIPOLAR TRANSISTOR BASE STRUCTURE COUPLED TO FIELD EFFECT TRANSISTOR GATE STRUCTURE**

(30) Priority: 10.01.2024 US 202418408708
(71) Applicant: GlobalFoundries U.S. Inc., Malta, NY 12020 (US)
(72) Inventor: Zhao, Zhixing, Nanjing, 211100 (CN); Mulaosmanovic, Halid, 01109 Dresden (DE); Baars, Peter, 01109 Dresden (DE)
(74) Representative: Grünecker Patent- und Rechtsanwälte PartG mbB

(57) **Abstract**

Embodiments of the disclosure provide a structure including a first back-gate well adjacent a second back-gate well. A bipolar transistor (BT) is over the first back-gate well and includes a base structure laterally between a set of emitter/collector (E/C) terminals and extending longitudinally away from the set of E/C terminals. A field effect transistor (FET) is over the second back-gate well and includes a gate structure laterally between a set of source/drain (S/D) terminals and extending longitudinally away from the set of S/D terminals toward the BT. The gate structure is coupled to the base structure.

## Description

### STATEMENT REGARDING FEDERAL RIGHTS

This invention was made with government support under DARPA T-MUSIC program Agreement No. HR0011-20-3-0002 awarded by the United States Department of Defense. The government has certain rights in the invention.

### BACKGROUND

The present disclosure provides a bipolar transistor base structure coupled to field effect transistor gate structure.

Conventional integrated circuits may employ heterojunction bipolar transistors (HBTs). Historically, HBTs were vertically oriented. Lateral bipolar transistors are currently under development, at least in part, to allow for easy integration into complementary metal oxide semiconductor (CMOS) process flows for semiconductor-on-insulator structures (e.g., silicon-on-insulator (SOI) structures). Efficiently integrating lateral bipolar transistors into the same device layer as field effect transistors (FETs) is a technical challenge.

### SUMMARY

The illustrative aspects of the present disclosure are designed to solve the problems herein described and/or other problems not discussed.

Embodiments of the disclosure provide a structure including: a first back-gate well adjacent a second back-gate well; a bipolar transistor (BT) over the first back-gate well and including a base structure laterally between a set of emitter/collector (E/C) terminals and extending longitudinally away from the set of E/C terminals; and a field effect transistor (FET) over the second back-gate well and including a gate structure laterally between a set of source/drain (S/D) terminals and extending longitudinally away from the set of S/D terminals toward the BT, wherein the gate structure is coupled to the base structure.

Other embodiments of the disclosure provide a structure including: a first back-gate well on a substrate and having a first back-gate contact thereto; a second back-gate well on the substrate adjacent the first back-gate well, and having a second back-gate contact thereto; an insulator layer on the first back-gate well and the second back-gate well; a bipolar transistor (BT) on the insulator layer and over the first back-gate well, wherein the BT includes a base structure laterally between a set of emitter/collector (E/C) terminals and extending longitudinally away from the set of E/C terminals; a field effect transistor (FET) on the insulator layer and over the second back-gate well, wherein the FET includes a gate structure laterally between a set of source/drain (S/D) terminals and extending longitudinally away from the set of S/D terminals toward the BT; and a conductive coupling from the base structure of the BT to the gate structure of the FET.

Additional embodiments of the disclosure provide a method including: forming a first back-gate well adjacent a second back-gate well; forming a bipolar transistor (BT) over a first back-gate well, the BT including a base structure laterally between a set of emitter/collector (E/C) terminals and extending longitudinally away from the set of E/C terminals; and forming a field effect transistor (FET) over the second back-gate well, the FET including a gate structure laterally between a set of source/drain (S/D) terminals and extending longitudinally away from the set of S/D terminals, wherein the gate structure is coupled to the base structure.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 shows a cross-sectional view of a bipolar transistor base structure coupled to a field effect transistor (FET) gate structure according to embodiments of the disclosure.
FIG. 2 shows a cross-sectional view of a FET gate structure coupled to a bipolar transistor base structure according to embodiments of the disclosure.
FIG. 3 shows a plan view of a structure according to embodiments of the disclosure.
FIG. 4 shows a cross-sectional view of an extrinsic base of a BT structure coupled to a gate conductor of a FET structure according to embodiments of the disclosure.
FIG. 5 shows a partial perspective view of a BT structure coupled to a gate conductor of a FET structure according to embodiments of the disclosure.
FIG. 6 shows a first cross-sectional view of a structure according to further embodiments of the disclosure.
FIG. 7 shows a plan view of a structure according to further embodiments of the disclosure.
FIG. 8 shows a second cross-sectional view of a FET gate structure coupled to a bipolar transistor base structure according to further embodiments of the disclosure.
FIG. 9 shows an example circuit diagram implemented via a structure according to further embodiments of the disclosure.
FIG. 10 shows a second cross-sectional view of a FET gate structure coupled to a bipolar transistor base structure according to still further embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (a) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure provide a structure including a first back-gate well adjacent a second back-gate well. A bipolar transistor (BT), e.g., a heterojunction bipolar transistor (HBT), is over the first back-gate well and includes a base structure laterally between a set of emitter/collector (E/C) terminals and extending longitudinally away from the set of E/C terminals. A field effect transistor (FET) is over the second back-gate well and includes a gate structure laterally between a set of source/drain (S/D) terminals and extending longitudinally away from the set of S/D terminals toward the BT. The gate structure is coupled to the base structure. As compared with conventional device structures, embodiments of the disclosure may electrically couple the base of a bipolar transistor to the gate of the FET structure without intervening elements, thus defining a shared node for two different kinds of transistors. In some cases, a conductor may be on the physical interface between the base of the bipolar transistor structure and the gate of the FET structure. The base and gate materials may be joined lengthwise (i.e., along a plane extending perpendicularly with respect to the emitter-collector and/or source-drain connections), or in parallel with the emitter-collector and/or source/drain connections. Structures of the disclosure also may include back-gate terminals for independent or simultaneous biasing of the bipolar transistor structure and/or FET structure.

Bipolar transistors (BTs) may be in the form of heterojunction bipolar transistors (HBTs). Heterojunction bipolar transistors differ from other bipolar transistors, e.g., by including different types of semiconductor materials together with different types of doping. As discussed herein, the base of an HBT may be silicon germanium (SiGe) whereas the emitter and collector terminals may include crystalline silicon (Si). HBTs and other BJT structures operate using multiple "P-N junctions." The term "P-N" refers to two adjacent materials having different types of conductivity (i.e., P-type and N-type), which may be induced through dopants within the adjacent material(s). Doping generally refers to a process by which foreign materials ("dopants") are added to a semiconductor structure to alter its electrical properties, e.g., resistivity and/or conductivity. Where a particular type of doping (e.g., p-type or n-type) doping is discussed herein, it is understood that an opposite doping type may be implemented in alternative embodiments. Implantation, where applicable, refers to a doping process in which ions are accelerated toward a solid surface to penetrate the solid up to a predetermined range based on the energy of the implanted ions. Doping also may be implemented by epitaxially growing different conductivity type semiconductor materials in contact with each other, i.e., in-situ doping during epitaxy. In-situ doped epitaxy may be particularly suitable to form HBT structures as discussed herein.

A P-N junction, when formed in a device, may operate as a diode. A diode is a two-terminal element, which behaves differently from conductive or insulative materials between two points of electrical contact. Specifically, a diode provides high conductivity from one contact to the other in one voltage bias direction (i.e., the "forward" direction), but provides little to no conductivity in the opposite direction (i.e., the "reverse" direction). In the case of the P-N junction, the orientation of a diode's forward and reverse directions may depend on the type and magnitude of bias applied to the material composition of one or both terminals, affecting the size of the potential barrier. In the case of a junction between two semiconductor materials, the potential barrier will be formed along the interface between the two semiconductor materials.

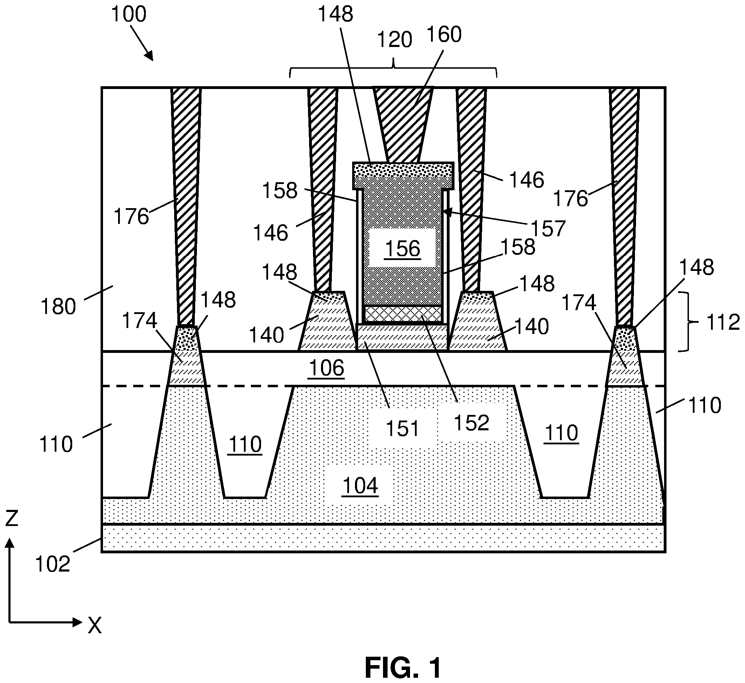

Referring to FIG. 1, a structure 100 according to embodiments of the disclosure is shown. Structure 100 may be on a substrate 102 including, e.g., one or more semiconductor materials. Substrate 102 may include but is not limited to silicon, germanium, silicon germanium (SiGe), silicon carbide (SiC), or any other common IC semiconductor substrates. In the case of SiGe, the germanium concentration in substrate 102 may differ from other SiGe-based structures described herein. A portion or entirety of substrate 102 may be strained, and/or may be doped to any desired polarity or concentration. In addition, some portions of substrate 102 may be doped to provide deep wells, e.g., for other device structures on substrate 102 not explicitly shown or discussed herein.

Structure 100 may include embedded elements for electrically separating active materials formed over substrate 102 from other regions and/or materials. Some areas of substrate 102 may be doped to provide a back-gate well 104. Back-gate well 104 can specifically be a monocrystalline semiconductor layer with P-type or N-type for conductivity and to allow electric biasing. Back-gate well 104 can be a doped bulk semiconductor material or, in other examples, may be a crystalline silicon layer or a monocrystalline layer of any other suitable semiconductor material (e.g., silicon germanium). An insulator layer 106 can be above substrate 102 and back-gate well 104. Insulator layer 106 can be, for example, an oxide layer (also referred to herein as a buried oxide (BOX) layer), such as a silicon dioxide layer, or a layer of any other suitable insulator material.

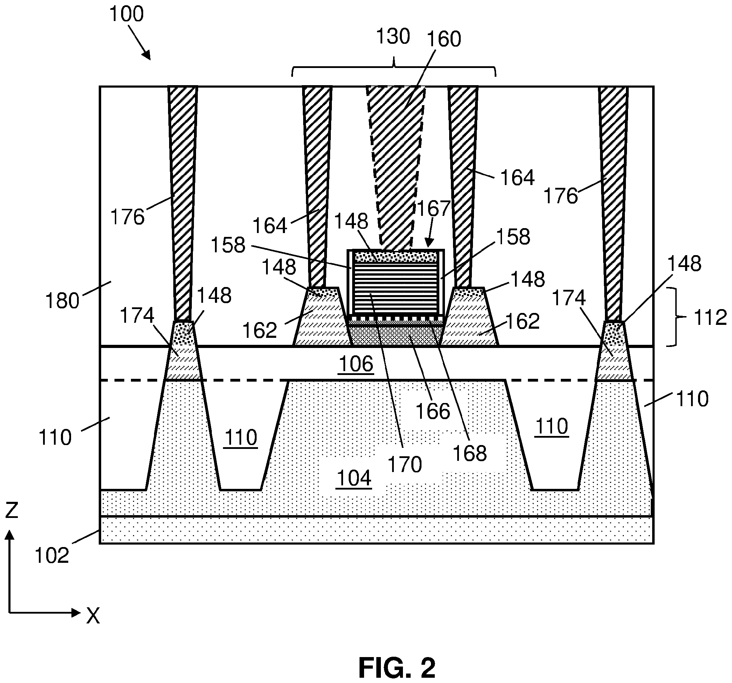

Structure 100 also may include one or more trench isolation layers (TI(s)) 110. TI(s) 110 may be made by forming and filling trenches (not labeled) with an insulating material such as oxide. TI(s) 110 horizontally isolate insulator layer 106, back-gate well 104, and other components thereon (e.g., bipolar transistor and field effect transistor (FET) structures discussed herein) from any adjacent regions of material. Various portions of structure 100, including the active semiconductor materials thereof and/or other devices where applicable, may be formed on or above portions of insulator layer 106 that are isolated by TI(s) 110. Any number of TI(s) 110 may be provided to isolate structure 100 from different types of structures and/or components. An active semiconductor layer 112 (e.g., a semiconductor on insulator (SOI) layer and/or other layer(s) of doped semiconductor material) on insulator 106 and separated from other structures by TI(s) 110 can define an active device region for a lateral bipolar junction transistor (BT) structure 120 (and, as discussed elsewhere herein, a field effect transistor (FET) structure 130 (FIG. 2)) over substrate 102. TI(s) 110 may be formed before active semiconductor layer 112 is formed over substrate 102, but this is not necessarily true in all implementations.

Insulator layer 106 and TI(s) 110 may be formed of any currently-known or later developed substance for providing electrical insulation, and as examples may include: silicon nitride (Si₃N₄), silicon oxide (SiO₂), fluorinated SiO₂ (FSG), hydrogenated silicon oxycarbide (SiCOH), porous SiCOH, boro-phospho-silicate glass (BPSG), silsesquioxanes, carbon (C) doped oxides (i.e., organosilicates) that include atoms of silicon (Si), carbon (C), oxygen (O), and/or hydrogen (H), thermosetting polyarylene ethers, a spin-on silicon-carbon containing polymer material, near frictionless carbon (NFC), or layers thereof. Active semiconductor layer 112 may be on insulator layer 106, e.g., due to being formed by deposition and epitaxial growth of semiconductor material(s). In other cases (e.g., where an SOI stack is not used), active semiconductor layer 112 and TI(s) 110 may be planarized (e.g., by chemical mechanical planarization or other technique(s)) such that the upper surface(s) thereof is/are substantially coplanar with each other) such that the upper surface of active semiconductor layer 112 is substantially coplanar with TI(s) 110.

Insulator layer 106 may extend horizontally throughout structure 100, and/or may be the layer on which active materials are formed and/or defined. In further implementations, insulator layer 106 may include oxygen doping to form a dielectric insulator or a buried oxide ("BOX") layer over substrate 102 and back-gate well 104 to electrically isolate overlying active materials from back-gate well 104 and/or substrate 102. Insulator layer 106 thus may include other elements or molecules such as Ge, N, or Si. However embodied, insulator layer 106 may be sized as narrow as possible to provide better interaction with overlying semiconductor materials. In various embodiments, insulator layer 106 may have a vertical thickness of approximately twenty nanometers (nm), or otherwise have a thickness that varies between approximately ten nm to approximately one-hundred nm. Some portions (not shown) of substrate 102 and/or back-gate well 104 may not have insulator layer 106 thereover, and/or multiple layers of insulator layer 106 may be formed on substrate 102 to varying thicknesses. Additionally, various conductive particles ("dopants") may be introduced into substrate 102 as discussed herein via a process known as "pre-doping" of substrate 102. It is understood that substrate 102 can be separately connected and used as a "back bias" to modify the operation of some or all of the devices located above the insulator layer 106, even though such couplings are not explicitly shown in the accompanying figures for clarity of illustration.

BT structure 120 can be formed on and within a portion of active semiconductor layer 112 bounded within TI(s) 110. Embodiments of structure 100 structurally integrate BT structure 120 with FET structure 130 (FIG. 2) by intercoupling the base and gate of each structure 120, 130 as discussed herein. The forming of structure 100 may include, e.g., providing a fully depleted semiconductor on insulator (FDSOI) substrate including a thin layer of insulative material between two semiconductor layers. Various isolation regions (i.e., TI(s) 110 discussed herein) are patterned to expose parts of the substrate that initially are below the insulator layer. Various gate structures (e.g., dummy gates) may be formed on the upper semiconductor layer of the FDSOI substrate. Spacers 158 are then formed on the gate structures, and one or more of the gate structures may be removed and replaced with functional transistor gates or base structure for an HBT as discussed herein. Emitter/collector (E/C) layers 140 can be formed by epitaxial growth on opposite sides of the initial gate (e.g., dummy gate) structure or eventual base structure. However formed, E/C terminals 140 may be doped, e.g., by in-situ doping and/or doping during formation of semiconductor material over insulator layer 106 and/or back-gate well 104. According to an example, E/C terminals 140 may have the same doping polarity as back-gate well 104, e.g., they each may have n-type doping. It is understood that localized implants and/or dopant diffusion from subsequent anneal steps may result in dopants of the same type as E/C terminal 140 also being in portions of back-gate well 104 below E/C terminals 140. E/C terminals 140 optionally may have a different composition (e.g., silicon germanium (SiGe)) relative to back-gate well 104

A set of E/C contacts 146 may provide the vertical electrical coupling between E/C terminals 140 and overlying metal wires and/or vias. Some portions of E/C terminals 140 may be converted into a silicide layer 148 to improve conductivity between E/C terminals 140 and E/C contact(s) 146 thereon, e.g., by providing a conductive metal such as cobalt (Co), titanium (Ti), nickel (Ni), platinum (Pt), or similar material on the upper surface(s) of a targeted material. The conductive material may be annealed while in contact with the underlying semiconductor to produce silicide layer 148 for electrically coupling semiconductor materials to any contacts formed thereon. Excess conductive material can then be removed using any now known or later developed solution, e.g., etching.

BT structure 120 includes an intrinsic base 152 on an SOI layer 151 (i.e., a non-doped or lightly doped semiconductor material) that is horizontally between E/C terminals 140, and an extrinsic base 156 on intrinsic base 152. SOI layer 151, intrinsic base 152, and extrinsic base 156 together provide a base structure 157 to control current flow between E/C terminals 140. Base structure 157 itself defines the base terminal of BT structure 120. Intrinsic base 152 may be p-type doped monocrystalline SiGe, and/or similar semiconductor materials having an opposite conductivity type from E/C terminals 140 but with relatively low amounts of doping. Intrinsic base 152 may be located on SOI layer 151 and above insulator layer 106, above back-gate well 104. Intrinsic base 152 may be grown on SOI layer 151 during any conventional replacement gate process and within spacers 158. Optionally, portions of SOI layer 151 may be removed to decrease its vertical thickness as much as possible, while retaining sufficient semiconductor material to enable epitaxial growth thereon. The doping type of intrinsic base 152 may be adjustable to provide NPN or PNP-conductivity types in a bipolar transistor. Extrinsic base 156 may have the same doping polarity as intrinsic base 152 but with a higher dopant concentration. Extrinsic base 156 may be formed by selective epitaxial growth of polycrystalline semiconductor in an opening above intrinsic base 152, followed by non-selective growth of additional, non-polycrystalline semiconductor material.

BT structure 120 also may include a set of spacers 158 on outer surfaces of extrinsic bases 156 and intrinsic base 152. Spacers 158 can be provided as one or more bodies of insulating material formed on the upper surface of a material, e.g., by deposition, thermal growth, etc., to electrically and physically insulate materials subsequently formed on the coated material(s) from other components. According to an example, spacers 158 may have one or more nitride insulator materials (e.g., SiN) or other types of insulator materials (e.g., SiO₂) formed to a desired thickness. In this case, spacers 158 may be formed, e.g., by nitriding exposed outer surfaces (e.g., sidewalls) of an initial gate structure (e.g., a "dummy gate") to convert its material composition into a nitride insulator (e.g., converting from poly-Si to silicon dioxide (SiN) or other semiconductor oxides).

In addition to providing electrical insulation, spacers 158 may affect the shape of extrinsic base 156 over intrinsic base 152. For instance, extrinsic base 156 may be substantially T-shaped by having a lower portion that is horizontally between (e.g., physically constrained by) spacers 158, and an upper portion that extends horizontally over (and thus overhangs) spacers 158. Extrinsic base 156 may have a substantial T-shape as a result of forming base structure 156 within spacers 158, i.e., by forming an initial gate structure (not shown) and replacing the initial gate structure with base structure 157. An advantage of this processing configuration is to provide more contact area for contacts to land on base structure 157. However, in further implementations, extrinsic base 156 may have any of a variety of structural configurations that are not T-shaped. The position and size of spacers 158 may be controlled during processing to further affect the size and shape of extrinsic base 156. It is understood that base material may be formed to have other geometries (e.g., shapes other than a "T") by omitting or changing the shape or position of spacers 158. Extrinsic base 156 also may include silicide layer 148 thereon for stronger coupling to a base contact 160 (also known simply as a "conductor" in some contexts). Silicide layer 148 may be formed by the same process, or in the same stage of processing, as other materials having silicide layer 148 discussed herein.

Referring now to FIG. 2, a second cross-section in plane X-Z of structure 100 is shown, in which the cross-section of FIG. 2 is positioned behind (or in front) of the plane depicted in FIG. 1. Structure 100 may include FET structure 130 in which a pair of source/drain (S/D) terminals 162 may be on insulator layer 106. S/D terminals 162 each may have the same (or similar) material composition to E/C terminal(s) 140 (FIG. 1). S/D terminal(s) 162, however, may have a different conductivity type from E/C terminal(s) 140, e.g., they may be doped p-type in the case where E/C terminal(s) 140 are doped n-type or vice versa. S/D terminal(s) 162 also may include silicide layer(s) 148 thereon to improve electrical conductivity to an S/D contact 164 to each S/D terminal 162.

FET structure 130 includes a channel layer 166 horizontally between S/D terminals 162. Channel layer 166 also may be above back-gate well 104 and insulator layer 106 but may have an opposite doping type as compared to S/D terminals 162. In the case where BT structure 120 provides an "NPN" transistor structure, intrinsic base 152 and channel layer 166 may have opposite doping types. Back-gate well 104 itself may define a back-gate terminal for BT structure 120 and/or FET structure 130 as discussed in detail herein.

Other portions of FET structure 130 may be between S/D terminals 162, and over channel layer 166. FET structure 130 for instance may include a gate structure 167, which may be structurally and compositionally distinct from base structure 157 because it is structure to operate a different type of transistor. Gate structure 167 may have a gate dielectric layer 168 in the form of any thin layer of dielectric material capable of preventing electrical coupling between channel region 166 and electrically active material(s) over gate dielectric layer 168 while allowing electric fields within a gate conductor 170 to influence the electrical conductivity within channel region 166. Gate dielectric layer 168 may include, e.g., a "high-k" dielectric material (i.e., any material having a dielectric constant of at least 3.9) or other currently known or later developed gate dielectric materials, and as examples may include hafnium silicate (HfSiO), hafnium oxide (HfO₂), zirconium silicate (ZrSiOₓ), zirconium oxide(ZrO₂), silicon oxide (SiO₂), silicon nitride (Si₃N₄), silicon oxynitride (SiON), or any combination of these materials.

Gate structure 167 also may include a gate conductor 170 including a conductive metal (e.g., copper, aluminum, and/or other metal wiring materials), and/or an active semiconductor material (e.g., doped polycrystalline Si and/or SiGe) may be over gate dielectric layer 168. In the case where gate conductor 170 includes active semiconductor material, gate conductor 170 may include silicide layer 148 thereon for improving the electrical interface between gate conductor 170 and metal wires and/or vias coupled thereto. Base contact 160 (shown in dashed lines to indicate being in a different X-Z cross-section) may vertically couple gate conductor 170 to metal wires, vias, and/or other components through wiring layers (not shown). Another set of spacers 158 also may cover sidewalls of gate conductor 170, e.g., in a manner similar to that of extrinsic base 156. Gate conductor 170 may have a different composition from extrinsic base 156, e.g., gate conductor 170 may be metal and extrinsic base 156 may include a doped semiconductor material, or gate conductor 170 may have a different doped semiconductor material from extrinsic base 156.

Referring to FIGS. 1 and 2 together, back-gate well 104 can be electrically coupled to a back-gate terminal 174 to further influence the characteristics of BT structure 120 (FIG. 1) and/or FET structure 130 (FIG. 2), e.g., the conductivity within E/C terminals 140 (FIG. 1), intrinsic base 152 (FIG. 1), S/D terminals 162 (FIG. 2), and channel region 166 (FIG. 2). Concurrent back biasing of BT structure 120 and FET structure 130 can be achieved by applying a single biasing voltage ("Vbg") to back-gate terminal 174, which in turn electrically biases the interconnected portions of back-gate well 104 below insulator layer 106 and below structures 120, 130. In some embodiments, structures 120, 130 can be zero back biased (e.g., by applying a Vbg of 0.0V to back-gate terminal 174). In other embodiments, structures 120, 130 could be either forward back biased or reversed back biased. Those skilled in the art will recognize that forward back biasing (FBB) refers to biasing conditions where the particular Vbg causes the emitter or collector of BT structure 120 to be at a higher potential or reduces the threshold voltage of FET structure 130. Reverse back biasing (RBB) refers to biasing conditions where the particular Vbg has opposite effects on BT structure 120 (e.g., it may put the collector at a higher potential in the case where FBB puts the emitter at a higher potential) or increased the threshold voltage of FET structure 130. Back-gate well 104 may extend below each structure 120, 130 to allow the same amount of back biasing to be applied to each structure 120, 130, or different portions of back-gate semiconductor layer may be separated by insulative materials and/or oppositely doped semiconductor materials to allow each structure 120, 130 to be biased through its own back-gate terminal 174.

A back-gate contact 176 may be on back-gate terminal 174 (e.g., it may be in contact with silicide layer 148) to provide electrical coupling between back-gate well 104 and overlying metal wires and/or vias. As with other semiconductive components discussed herein, silicide layer 148 may be on back-gate terminal 174. Applying an electrical potential to back-gate well 104 through back-gate terminal 174 can induce an electric charge within back-gate well 104, thereby creating a difference in electrical potential between back-gate well 104 and other semiconductive materials (e.g., E/C terminals 140, SOI layer(s) 151, S/D terminals 162, channel layer 166, etc.) across insulator layer 106. Among other effects, this difference in electrical potential between back-gate well 104 and overlying semiconductor layers can affect electrical properties, e.g., the biasing of BT structure 120, FET structure 130, etc. For instance, electrical biasing of back-gate well 104 can raise or lower threshold voltage of FET structure 130, i.e., the minimum voltage for inducing electrical conductivity across channel region 166 between S/D terminals 162.

Structure 100 may include an inter-level dielectric (ILD) layer 180 over insulator layer 106 and any other components thereon. ILD layer 180 may include the same insulating material as insulator layer 106 or may include a different electrically insulative material for vertically separating active materials from overlying materials, e.g., various horizontally extending wires or vias. ILD layer 180 and insulator layer 106 nonetheless constitute different components, e.g., due to insulator layer 106 being vertically between back-gate well 104 and the various components of BT structure 120, FET structure 130, etc. ILD layer 180 may be formed by deposition and/or other techniques to provide electrically insulating materials, and can then be planarized (e.g., using CMP), such that its upper surface remains above active semiconductor layer 112, BT structure 120, FET structure 130, etc.

As discussed previously, structure 100 includes various contacts 146, 160, 164, 176 for electrically coupling structure 100 to overlying metal wires or vias (not shown). Contacts 146, 160, 164, 176 may be formed within predetermined portions of ILD layer 180 by a controlled amount of vertical etching to form openings to one or more contact sites, and then filling the openings with a conductor. Each contact 146, 160, 164, 176 may include any currently known or later developed conductive material configured for use in an electrical contact, e.g., tungsten (W), copper (Cu), aluminum (Al), etc. Contacts 146, 160, 164, 176 may additionally include refractory metal liners (not shown) positioned alongside ILD layer 180 to prevent electromigration degradation, shorting to other components, etc.

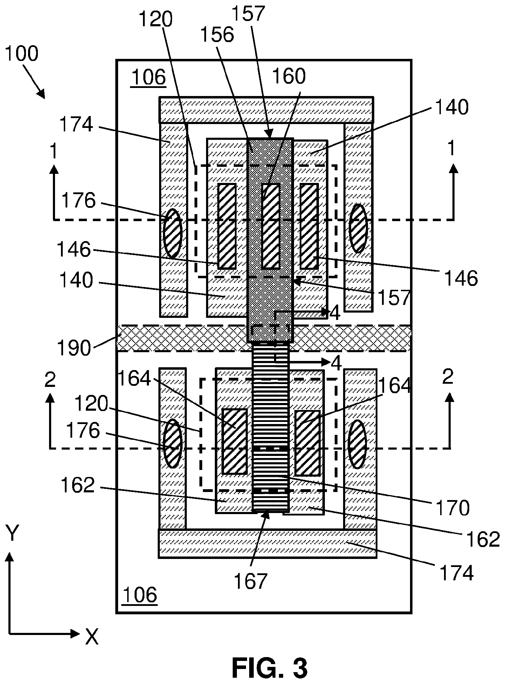

FIG. 3 depicts a plan view of structure 100 with the cross-sectional view shown in FIG. 1 indicated through view line 1-1 and the cross-sectional view shown in FIG. 2 indicated through view line 2-2. Optionally, BT structure 120 and FET structure 130 may be coupled together through one conductor (e.g., base contact 160) that is shared between base structure 157 and gate structure 167. In this case, only extrinsic base 156 or gate conductor 170 may have a contact thereon. To provide this feature, a portion of extrinsic base 156 may overlap and physically interface with gate conductor 170 at a location that is longitudinally between BT structure 120 and FET structure 130. That is, the emitter-collector connection through BT structure 120 may extend in a lateral direction in parallel with the source-drain connection through FET structure 130, allowing extrinsic base 156 and gate conductor 170 to extend longitudinally over substrate 102 in a direction that is perpendicular to the source-drain and emitter-collector orientations. Among other benefits, coupling of base structure 157 to gate structure 167 may allow a single node to control multiple transistor structures 120, 130, and/or reduce the number of wiring layers and/or conductive vias needed to operate structure 100.

To electrically separate each transistor structures 120, 130 and different portions of back-gate well 104 (FIGS. 1, 2) from each other, a deep well barrier 190 (e.g., semiconductor material having an opposite doping type from active semiconductor materials in structure 100) may be horizontally between the two pairs of transistor structures 120, 130 (e.g., horizontally between transistor structures 120, 130 along the Y axis as shown). Although two pairs of transistor structures 120, 130 with deep well barrier 190 are shown in FIG. 3, it is understood that any desired number of paired transistor structures 120, 130 may be interconnected through their respective extrinsic base 156 and gate conductor 170.

Various embodiments of the disclosure may include methods to form structure 100. Such methods may include, e.g., forming back-gate wells 104 in substrate 102 such that at least one back-gate well 104 is adjacent another back-gate well, with TI(s) 110 therebetween. Further processing may include forming BT structure 120 over one back-gate well 104, e.g., by forming base structure 157 through metal gate replacement as discussed herein and subsequent forming of E/C terminals 140 by epitaxial growth, doping, and/or other combinations of techniques. Spacers 158 and E/C terminals 140 are formed after the forming of an initial ("dummy") gate, and replacement metal gate (RMG) techniques then may be implemented to form base structure 157 including intrinsic base 152 and extrinsic base 156. Base structure 157 may extend longitudinally away from E/C terminals 140 over substrate 102. Methods to form structure 100 similarly may include forming FET structure 130, in which gate structure 167 also may be formed by metal gate replacement, perhaps with one or more of the same metal gate replacement steps used to form base structure 157. FET structure 130 may be over a different back-gate well 104 and its gate structure 167 may extend longitudinally away from S/D terminals 162. Base structure 157 may be coupled to gate structure 167, e.g., by longitudinal abutting of structures 157, 167 and/or other types of intercoupling discussed herein. The forming of structures 157, 167 may include forming different semiconductor compositions in respective locations and/or forming a doped semiconductor to provide extrinsic base 156 and a conductive metal to provide gate conductor 170. Further processes to form structure 100 may include, e.g., forming back-gate terminals 174 configured to independently bias BT structure 120 and FET structure 130 through different back-gate wells 104.

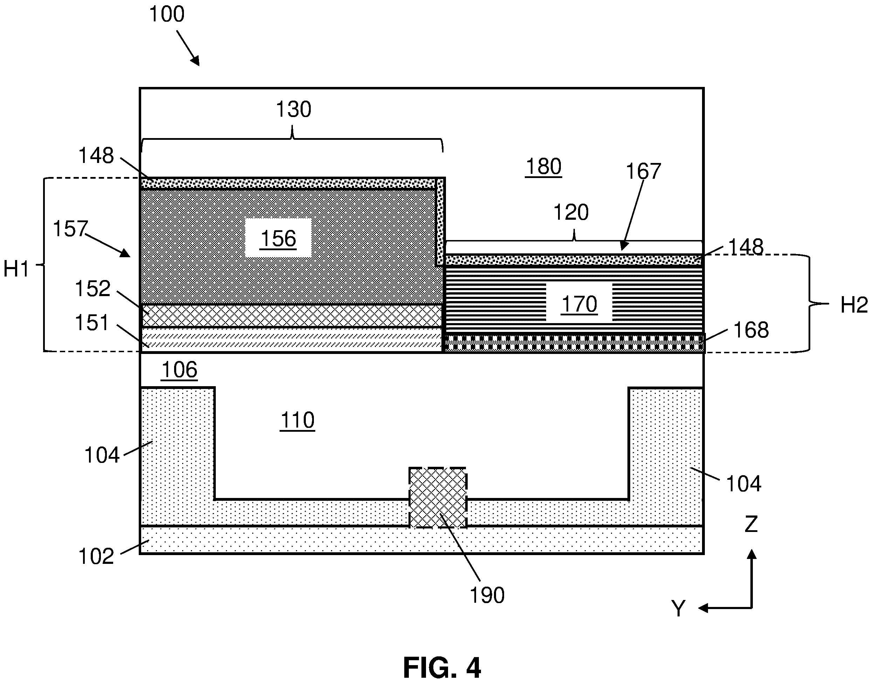

Referring to FIGS. 3 and 4 together, FIG. 4 indicates alone view line 4-4 of FIG. 3 (from top to bottom) that extrinsic base 156 of one BT structure 120 and gate conductor 170 of FET structure 130 may be intercoupled even where deep well barrier 190 separates back-gate well 104 into multiple regions. As shown in FIG. 3, base contact 160 may be on an upper surface of extrinsic base 156 and gate conductor 170 may not have a corresponding contact thereon. However, extrinsic base 156 and gate conductor 170 may be electrically coupled together and substantially aligned in a direction parallel to the source-drain and emitter-collector connections of structure 100. Despite the intercoupling of extrinsic base 156 to gate conductor 170, BT structure 120 and FET structure 130 each may have an independently controllable back-gate bias applied thereto. In such cases, separate back-gate contacts 176 to each structure 120, 130 may be provided to control the amount of back-gate biasing (e.g., as shown in FIG. 2).

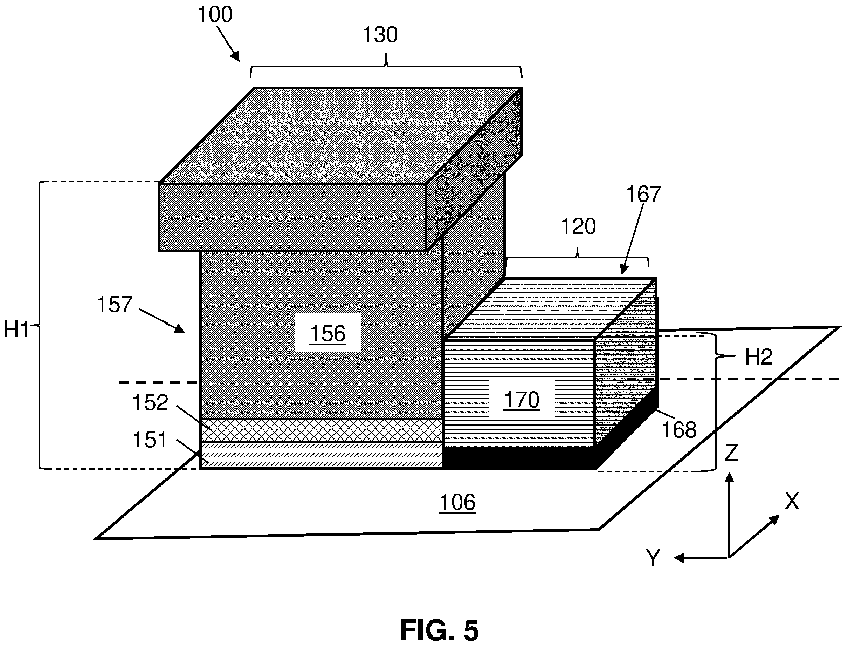

Referring to FIGS. 4 and 5, in which FIG. 5 provides a perspective view omitting certain components (e.g., back-gate well 104, silicide layers 148, etc.) solely to better illustrate examples of extrinsic base 156 and gate conductor 170 shapes, embodiments of structure 100 may intercouple BT structure 120 to FET structure 130 by providing a physical interface between extrinsic base 156 and gate conductor 170. For example, extrinsic base 156 and gate conductor 170 each may have sidewall surfaces that abut each other to define an electrical pathway from base structure 157 to gate structure 167. Some portions of SOI layer 151 and/or intrinsic base 152 may abut gate dielectric layer 168 and/or gate conductor 170, but this will not meaningfully affect the conductive pathway between extrinsic base 156 and gate conductor 170. In any case, a lower surface of base structure 157 (e.g., a lower surface of SOI layer 151) may be substantially coplanar with a lower surface of gate structure 167 (e.g., they both may be on insulator layer 106).

Silicide layer 148 (FIG. 4 only) may be formed on each of extrinsic base 156 and gate conductor 170 where applicable, e.g., by a single implementation of silicidation techniques and thus silicide layer 148 optionally may extend continuously from base structure 157 to gate structure 167. The area of contact between extrinsic base 156 and gate conductor 170 may be located over deep well barrier 190 (FIG. 4). This configuration may better isolate the back-gate biasing of BT structure 120 in some areas of back-gate well 104 from the back-gate biasing of FET structure 130 in other areas of back-gate well 104. In other implementations, deep well barrier 190 may be located elsewhere beneath base structure 157, gate conductor 170, and/or may be omitted entirely.

As shown specifically in FIG. 5, embodiments extrinsic base 156 that are substantially T-shaped may abut gate conductor 170 along its narrower lower portion, but this is not necessarily required. Furthermore, SOI layer 151 and base structure 157 together may have a height H1 above insulator layer 106 that is greater than a height H2 of gate structure 167 over insulator layer 106. Height H1 being greater than height H2 may arise from the process(es) discussed herein to form base structure 157 from an initial (e.g., "dummy") gate structure. In other implementations, height H2 may be larger than height H1.

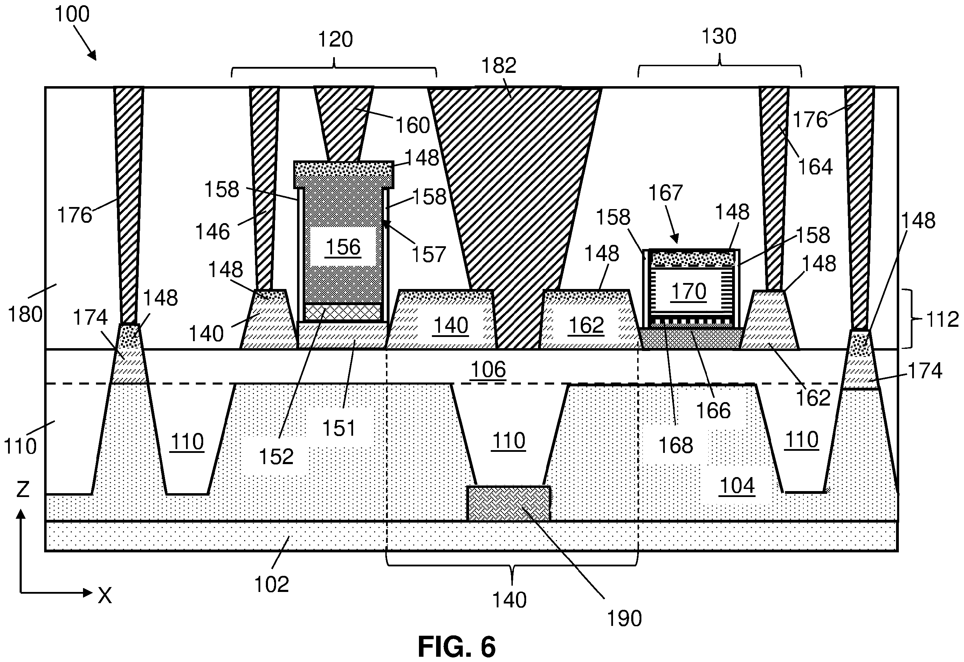

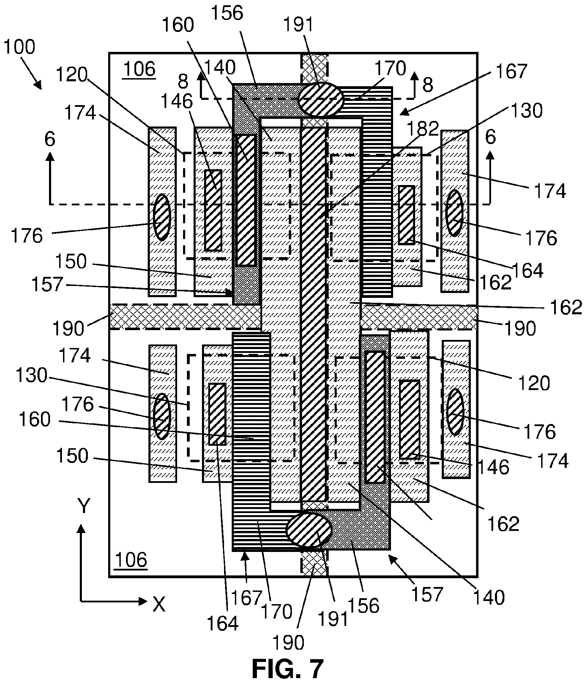

Referring now to FIGS. 6 and 7, further implementations of structure 100 may allow base structure 157 to be coupled to gate conductor 170 via configurations other than those depicted in FIGS. 3-5. For example, structure 100 may include multiple types of transistors (e.g., BT structure 120 and FET structure 130) over substrate 102 within one X-Y cross-section. A possible benefit of such a configuration is the ability to form an intermediate contact 182, which is coupled to (and thus shared between) one E/C terminal 140 and one S/D terminal 162. Intermediate contact 182 may extent vertically through ILD layer 180 to an upper surface of insulator layer 106, such that portions of intermediate contact 182 are coupled to sidewalls and upper surfaces of layers 140, 162 and any silicide layers 148 thereon. Intermediate contact 182, in addition, may be located over another deep well barrier 190 that is located between two portions of back-gate well 104. Deep well barrier 190 may allow BT structure 120 to have different back gate biasing from FET structure 130, even where both structures 120, 130 are substantially laterally aligned (i.e., adjacent along the X-axis as shown).

Furthermore, as shown in FIG. 7, structure 100 may include multiple pairs of laterally adjacent BT structures 120 and FET structures 130 (e.g., each pair may be in parallel with the other along the X-axis). Here, two deep well barriers 190 may be provided in a cross-type configuration to enable back-gate biasing of all four structures 120, 130 in four different locations via four back-gate contacts 176. In each pair of structures 120, 130, base structure 157 may be electrically coupled to gate conductor 170 in a location that is longitudinally distal to the cross-section(s) between E/C terminals 140 and S/D terminals 162 (e.g., as indicated in FIG. 6). For instance, each base structure 157 and gate structure 167 may be substantially L-shaped and together may define a substantial U-shape in plane X-Y, with longitudinally oriented sections between layers 140, 162 that transition to laterally-oriented sections that meet each other along a different X-Y plane.

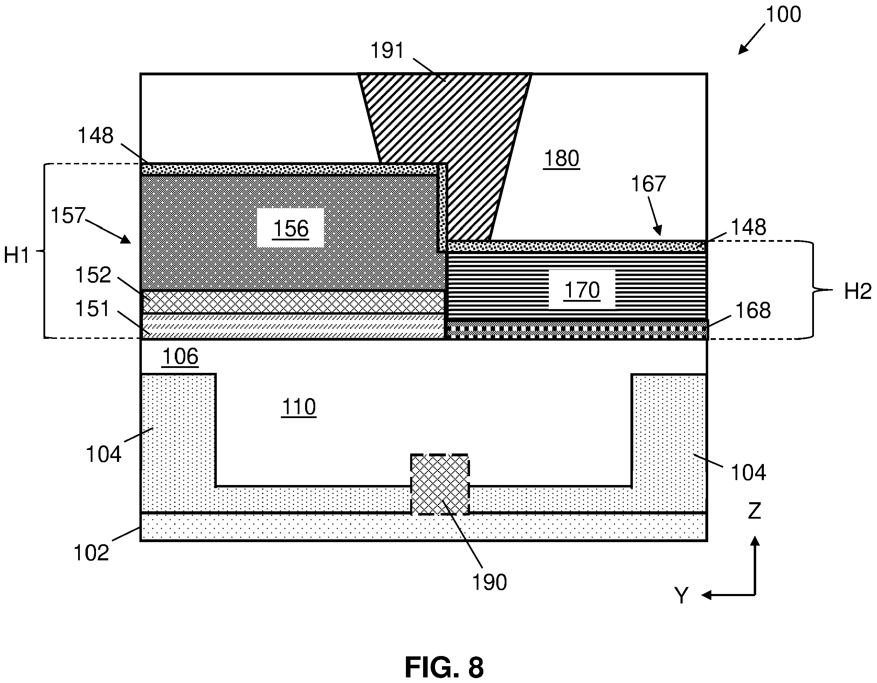

Referring to FIGS. 7 and 8 together, embodiments of structure 100 may enable coupling of base structure 157 to gate conductor 170 in a different configuration from other embodiments discussed herein. In the cross-section viewed along line 8-8 (FIG. 7), extrinsic base 156 and gate conductor 170 each may have sidewall surfaces in plane X-Y that laterally abut each other to define an electrical pathway from base structure 157 to gate conductor 170. Some portions of SOI layer 151 and/or intrinsic base 152 may abut gate dielectric layer 168 and/or gate conductor 170, but this will not meaningfully affect the conductive pathway between extrinsic base 156 and gate conductor 170. Silicide layer 148 (FIG. 8 only) may be formed on each of extrinsic base 156 and gate conductor 170 where applicable, e.g., by a single implementation of silicidation techniques and thus silicide layer 148 optionally may extend continuously from base structure 157 to gate structure 167. The area of contact between extrinsic base 156 and gate conductor 170 may be located over deep well barrier 190. This configuration may better isolate the back-gate biasing of each BT structure 120 in some areas of back-gate well 104 from the back-gate biasing of its interconnected FET structure 130 in other areas of back-gate well 104. In other implementations, deep well barrier 190 may be located elsewhere beneath base structure 157, gate conductor 170, and/or may be omitted entirely.

Referring specifically to FIG. 8, embodiments of the disclosure may include a conductor 191 (e.g., one or more conductive metals included in various contacts discussed herein and/or other conductive materials) over extrinsic base 156 and/or gate conductor 170 to enhance electrical conductivity therebetween. For instance, conductor 191 may be located over (and thus may laterally traverse) the interface between base structure 157 and gate structure 167. However, this is not required in all implementations. Elsewhere in structure 100 and/or in other implementations, base contact 160 may be solely on base structure 157, yet still coupled to gate conductor 170 through extrinsic base 156. Base contact 160 may be on extrinsic base 156 as shown in FIGS. 6 and 7. However, base contact 160 is also operable to control FET structure 130 via gate conductor 170, as it is electrically coupled to gate conductor 170 through extrinsic base 156 without having meaningful voltage or signal loss within gate conductor 170.

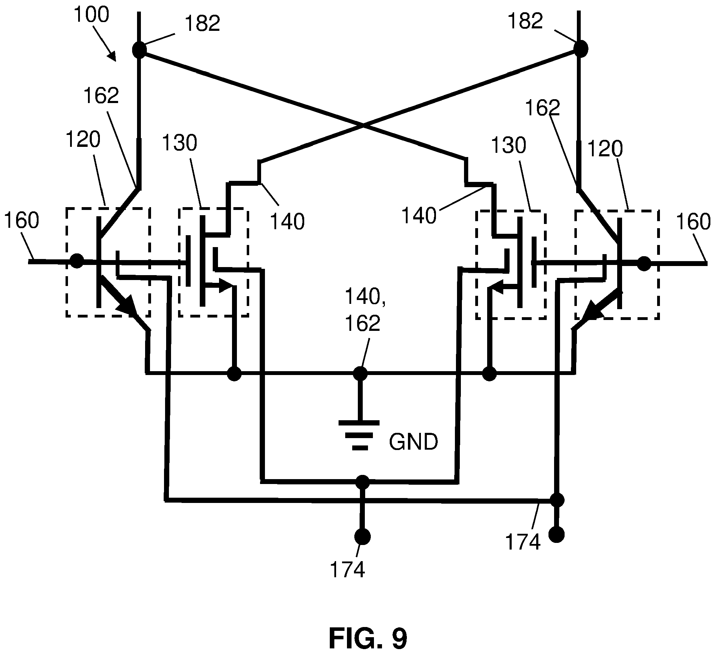

Turning to FIGS. 7-9 together, in which FIG. 9 provides a circuit diagram implemented through structure 100, embodiments of the disclosure may provide additional technical features. As shown, each intermediate contacts 182 may tie together one E/C terminal 140 to one S/D terminal 162, whereas each of the other layers 140, 162 may be coupled to ground (GND) or a shared voltage node. Each base contact 160 may be coupled to the base terminal of BT structure 120 and the gate terminal of FET structure 130, such that base contact controls emitter-collector conductivity in BT structure 120 and source-drain conductivity in FET structure 130 simultaneously. The ability to provide this circuit in a relatively compact surface area arises, in part, from the direct electrical coupling of base structure 157 to gate structure 167 and/or the presence of intermediate contact(s) 182 as discussed herein. As also shown, back-gate terminals 174 each may be coupled to pairs of structures 120, 130, or in further embodiments each may be coupled to the back-gate terminal of only one structure 120, 130.

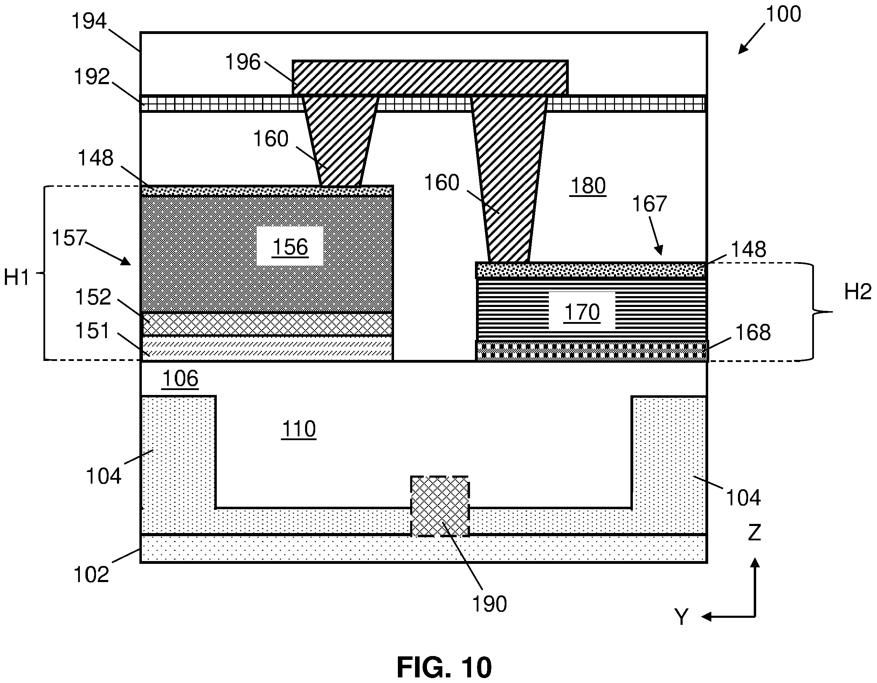

FIG. 10 illustrates a further configuration for coupling base structure 157 to gate structure 167, which may be implemented in plane X-Z or may be implemented in plane X-Y in a location similar to those shown in FIGS. 3 and 4. Embodiments of structure 100 may include, e.g., multiple base contacts 160 each coupling base structure 157 and gate structure 167 to an overlying wiring layer. The overlying wiring layer may include, e.g., a barrier film 192 (e.g., a nitride-based insulator, any currently known or later developed etch stop layer compositions, etc.) and an additional ILD layer 194 thereover. A metal wire 196 may be within additional ILD layer 194 and may horizontally couple one base contact 160 to another, thereby defining a conductive coupling from base structure 157 to gate structure 167. The configuration shown in FIG. 10 may allow base structure 157 to be coupled to gate structure 167 without any physical interfaces or direct electrical couplings between extrinsic base 156 and gate conductor 170, other than through contacts 160 and metal wire 196. Although metal wire 196 is shown by example to be in a wiring layer directly above base structure 157 and gate structure 167, it may be in any metal wiring layer of a device and thus any number of intervening metal wiring layers may be present. Despite physical differences between this implementation of structure 100 and others discussed elsewhere herein, structure 100 may be functionally indistinguishable from other implementations despite the presence or absence of additional base contacts 160 and/or metal wire(s) 196.

Embodiments of the disclosure may provide several technical advantages, examples of which are discussed herein. For example, embodiments of the disclosure allow BT structures 120 and FET structures 130 to be provided together over a single substrate and/or back-gate well 104 and electrically interconnected by coupling of base structure(s) 157 to gate structure(s) 167. The various operational advantages, circuits, and/or other features described herein may be achievable through interconnecting of extrinsic base 156 to gate conductor 170. This form of interconnection may not be conventionally achievable, e.g., because conventional processes do not form base structure(s) 157 through replacement metal gate (RMG) techniques because gate structure 167 is also present, e.g., by having been formed by a gate first (i.e. non-replacement metal gate) approach. These structural characteristics allow structure 100 to occupy less surface area on a device than conventional groups of bipolar transistors and FETs. During operation, the ability to apply the same or different back-gate bias to bipolar transistor structures 120 and FET structures 130 may accommodate higher performance requirements for certain bipolar transistors and may reduce total power consumption in a device.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/- 10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, embodiments of the disclosure provide a structure including a first back-gate well adjacent a second back-gate well. A bipolar transistor (BT) is over the first back-gate well and includes a base structure laterally between a set of emitter/collector (E/C) terminals and extending longitudinally away from the set of E/C terminals. A field effect transistor (FET) is over the second back-gate well and includes a gate structure laterally between a set of source/drain (S/D) terminals and extending longitudinally away from the set of S/D terminals toward the BT. The gate structure is coupled to the base structure.

The following embodiments are explicitly disclosed.
Embodiment 1: A structure comprising:
   a first back-gate well adjacent a second back-gate well;
   a bipolar transistor (BT) over the first back-gate well and including a base structure laterally between a set of emitter/collector (E/C) terminals and extending longitudinally away from the set of E/C terminals; and
   a field effect transistor (FET) over the second back-gate well and including a gate structure laterally between a set of source/drain (S/D) terminals and extending longitudinally away from the set of S/D terminals toward the BT, wherein the gate structure is coupled to the base structure.
   In illustrative examples herein, the first back-gate well may be electrically isolated from the BT, e.g., via an insulator layer interposed between the first back-gate well and the BT, and the second back-gate well may be electrically isolated from the FET, e.g., via an insulator layer interposed between the first back-gate well and the FET, the insulator layer below the FET either being identical with or different from the insulator layer below the BT.
Embodiment 2: The structure of embodiment 1, wherein the base structure longitudinally abuts the gate structure.
Embodiment 3: The structure of embodiment 1 or 2, further comprising a conductor over a longitudinal end of the base structure and a longitudinal end of the gate structure.
Embodiment 4: The structure of one of embodiments 1 to 3, wherein the base structure is substantially T-shaped.
Embodiment 5: The structure of one of embodiments 1 to 4, wherein an upper surface of the base structure is above an upper surface of the gate structure.
Embodiment 6: The structure of one of embodiments 1 to 5, wherein a material composition of the base structure is different from a material composition of the gate structure.
Embodiment 7: The structure of one of embodiments 1 to 6, further comprising:
   a first back-gate terminal configured to bias the BT and within the first back-gate well; and
   a second back-gate terminal configured to bias the FET and within the second back-gate well.
Embodiment 8: The structure of one of embodiments 1 to 7, further comprising:
   a substrate, wherein the first back-gate well is formed on the substrate, the first back-gate well having a first back-gate contact thereto, and wherein the second back-gate well is formed on the substrate adjacent the first back-gate well, and the second back-gate well having a second back-gate contact thereto; and
   an insulator layer on the first back-gate well and the second back-gate well,
   wherein the bipolar transistor (BT) is formed on the insulator layer and over the first back-gate well,
   wherein the field effect transistor (FET) is formed on the insulator layer and over the second back-gate well, and
   wherein the structure further comprises a conductive coupling from the base structure of the BT to the gate structure of the FET.
Embodiment 9: A structure comprising:
   a first back-gate well on a substrate and having a first back-gate contact thereto;
   a second back-gate well on the substrate adjacent the first back-gate well, and having a second back-gate contact thereto;
   an insulator layer on the first back-gate well and the second back-gate well;
   a bipolar transistor (BT) on the insulator layer and over the first back-gate well, wherein the BT includes a base structure laterally between a set of emitter/collector (E/C) terminals and extending longitudinally away from the set of E/C terminals;
   a field effect transistor (FET) on the insulator layer and over the second back-gate well, wherein the FET includes a gate structure laterally between a set of source/drain (S/D) terminals and extending longitudinally away from the set of S/D terminals toward the BT; and
   a conductive coupling from the base structure of the BT to the gate structure of the FET.
Embodiment 10: The structure of embodiment 8 or 9, wherein the conductive coupling includes a physical interface between the base structure and the gate structure.
Embodiment 11: The structure of one of embodiments 8 to 10, wherein the conductive coupling includes a conductor over a longitudinal end of the base structure and a longitudinal end of the gate structure, and wherein a portion of the conductor is on an upper surface of the insulator layer.
Embodiment 12: The structure of one of embodiments 1 to 11, wherein a bottom surface of the base structure is substantially coplanar with a bottom surface of the gate structure.
Embodiment 13: The structure of one of embodiments 1 to 12, wherein an upper surface of the base structure is above an upper surface of the gate structure.
Embodiment 14: The structure of one of embodiments 1 to 13, wherein a material composition of the base structure is different from a material composition of the gate structure.
Embodiment 15: A method comprising:
   forming a first back-gate well adjacent a second back-gate well;
   forming a bipolar transistor (BT) over the first back-gate well, the BT including a base structure laterally between a set of emitter/collector (E/C) terminals and extending longitudinally away from the set of E/C terminals; and
   forming a field effect transistor (FET) over the second back-gate well, the FET including a gate structure laterally between a set of source/drain (S/D) terminals and extending longitudinally away from the set of S/D terminals, wherein the gate structure is coupled to the base structure.
   In illustrative examples herein, the first back-gate well may be electrically isolated from the BT, e.g., via an insulator layer interposed between the first back-gate well and the BT, and the second back-gate well may be electrically isolated from the FET, e.g., via an insulator layer interposed between the first back-gate well and the FET, the insulator layer below the FET either being identical with or different from the insulator layer below the BT.
Embodiment 16: The method of embodiment 15, wherein forming the FET causes the gate structure to longitudinally abut the base structure.
Embodiment 17: The method of embodiment 15 or 16, further comprising forming a conductor over a longitudinal end of the base structure and a longitudinal end of the gate structure.
Embodiment 18: The method of one of embodiments 15 to 17, wherein a bottom surface of the base structure is substantially coplanar with a bottom surface of the gate structure.
Embodiment 19: The method of one of embodiments 15 to 18, wherein the base structure of the BT is substantially T-shaped.
Embodiment 20: The method of one of embodiments 15 to 19, wherein a material composition of the base structure is different from a material composition of the gate structure.
Embodiment 21: The method of one of embodiments 15 to 20, further comprising:
   forming a first back-gate terminal configured to bias the BT within the first back-gate well; and
   forming a second back-gate terminal configured to bias the FET within the second back-gate well.
Embodiment 22: The method of one of embodiments 15 to 21, wherein the structure of one of embodiments 1 to 14 is formed.

The term lateral and longitudinal may be understood as denoting mutual perpendicular directions, wherein longitudinal is defined as indicating a direction oriented along a length direction of at least one of a base structure and a gate structure, the length direction of the base structure and gate structure, respectively, being defined as a direction perpendicular to a direction along which emitter and collector are separated and along which source and drain are separated, respectively. Similarly, the length direction may be understood as indicating a direction perpendicular to a direction along which E/C terminals are separated.

## Claims

1. A structure comprising:
a first back-gate well adjacent a second back-gate well;
a bipolar transistor (BT) over the first back-gate well and including a base structure laterally between a set of emitter/collector (E/C) terminals and extending longitudinally away from the set of E/C terminals; and
a field effect transistor (FET) over the second back-gate well and including a gate structure laterally between a set of source/drain (S/D) terminals and extending longitudinally away from the set of S/D terminals toward the BT, wherein the gate structure is coupled to the base structure.

2. The structure of claim 1, wherein the base structure longitudinally abuts the gate structure, and/or wherein the base structure is substantially T-shaped.

3. The structure of claim 1 or 2, further comprising a conductor over a longitudinal end of the base structure and a longitudinal end of the gate structure.

4. The structure of one of claims 1 to 3, wherein an upper surface of the base structure is above an upper surface of the gate structure.

5. The structure of one of claims 1 to 4, wherein a material composition of the base structure is different from a material composition of the gate structure.

6. The structure of one of claims 1 to 5, further comprising:
a first back-gate terminal configured to bias the BT and within the first back-gate well; and
a second back-gate terminal configured to bias the FET and within the second back-gate well.

7. The structure of one of claims 1 to 6, further comprising:
a substrate, wherein the first back-gate well is formed on the substrate, the first back-gate well having a first back-gate contact thereto, and wherein the second back-gate well is formed on the substrate adjacent the first back-gate well, and the second back-gate well having a second back-gate contact thereto; and
an insulator layer on the first back-gate well and the second back-gate well,
wherein the bipolar transistor (BT) is formed on the insulator layer and over the first back-gate well,
wherein the field effect transistor (FET) is formed on the insulator layer and over the second back-gate well, and
wherein the structure further comprises a conductive coupling from the base structure of the BT to the gate structure of the FET.

8. The structure of claim 7, wherein the conductive coupling includes a physical interface between the base structure and the gate structure.

9. The structure of claim 7 or 8 in combination with claim 3, wherein a portion of the conductor is on an upper surface of the insulator layer.

10. The structure of one of claims 1 to 9, wherein a bottom surface of the base structure is substantially coplanar with a bottom surface of the gate structure, and/or wherein an upper surface of the base structure is above an upper surface of the gate structure.

11. A method comprising:
forming a first back-gate well adjacent a second back-gate well;
forming a bipolar transistor (BT) over the first back-gate well, the BT including a base structure laterally between a set of emitter/collector (E/C) terminals and extending longitudinally away from the set of E/C terminals; and
forming a field effect transistor (FET) over the second back-gate well, the FET including a gate structure laterally between a set of source/drain (S/D) terminals and extending longitudinally away from the set of S/D terminals, wherein the gate structure is coupled to the base structure.

12. The method of claim 11, wherein forming the FET causes the gate structure to longitudinally abut the base structure, and/or wherein the base structure of the BT is substantially T-shaped.

13. The method of claim 11 or 12, further comprising forming a conductor over a longitudinal end of the base structure and a longitudinal end of the gate structure.

14. The method of one of claims 11 to 13, wherein a bottom surface of the base structure is substantially coplanar with a bottom surface of the gate structure, and/or wherein a material composition of the base structure is different from a material composition of the gate structure.

15. The method of one of claims 11 to 14, further comprising:
forming a first back-gate terminal configured to bias the BT within the first back-gate well; and
forming a second back-gate terminal configured to bias the FET within the second back-gate well.
